Europäisches Patentamt

European Patent Office

Office européen des brevets

(19)

(11) Veröffentlichungsnummer: **0 314 858 B1**

# EUROPÄISCHE PATENTSCHRIFT

(12)

(45) Veröffentlichungstag der Patentschrift :
28.08.91 Patentblatt 91/35

(51) Int. Cl.$^5$ : **C30B 15/02**

(21) Anmeldenummer : 88103767.5

(22) Anmeldetag : 10.03.88

(54) Vorrichtung für die kontinuierliche Zufuhr von Schmelzgut.

(30) Priorität : 31.10.87 DE 3737051

(43) Veröffentlichungstag der Anmeldung :
10.05.89 Patentblatt 89/19

(45) Bekanntmachung des Hinweises auf die
Patenterteilung :
28.08.91 Patentblatt 91/35

(84) Benannte Vertragsstaaten :
DE FR GB IT NL SE

(56) Entgegenhaltungen :
EP-A- 0 170 856
US-A- 3 960 503
US-A- 3 998 686

(73) Patentinhaber : LEYBOLD
AKTIENGESELLSCHAFT
Wilhelm-Rohn-Strasse 25
W-6450 Hanau am Main 1 (DE)

(72) Erfinder : Drechsel, Dieter, Dr.
Fritz-Schubert-Ring 1
W-6454 Bruchköbel (DE)
Erfinder : Jericho, Karl
Theodor-Heuss-Strasse 73
W-6450 Hanau 9 (DE)

## Beschreibung

Die Erfindung betrifft eine Vorrichtung für die kontinuierliche Zuführung von Schmelzgut für den Schmelztiegel beim Ziehen von Einkristallen in einem Vakuumkessel mit einem verschließbaren Behälter, einer Rüttelvorrichtung und einem in den Schmelztiegel einmündenden, mit dem Behälter verbundenen Auslaufrohr.

Üblicherweise wird bei bekannten Vorrichtungen zum Ziehen von Einkristallen der Schmelztiegel vor dem Evakuieren des den Schmelztiegel umschließenden Kessels mit der notwendigen Menge an Schmelzgut, beispielsweise mit Siliziumgranulat, gefüllt. Man hat auch bereits vorgeschlagen (DE-OS 2821481), während des Stabziehens Siliziumgranulat nachzuchargieren, indem es durch ein beheiztes Quarzglasrohr nachgeführt wird, welches von außen durch die Rezipientenwand und den äußeren Teil der Vorrichtung in die Siliziumschmelze eintaucht.

Es ist weiterhin bekannt (EP 0170856), außerhalb des Kessels eine Zuführeinrichtung für das Siliziumgranulat anzuordnen, deren Auslaufrohr mit einem zylindrischen, teilweise mit Granulat gefüllten Behälter in Verbindung steht, in dem eine motorisch angetriebene Zumeßscheibe rotiert, die Vertiefungen aufweist, die sich mit Granulat füllen, wenn die Scheibe das auf der einen Seite des Behälters angehäufte Quantum an Granulat durchläuft. Die Scheibe transportiert dann die aufgenommene Portion an Granulat vor das eine Ende des Auslaufrohrs, so daß dieses dann über das Auslaufrohr bis in den Schmelztiegel abrutschen kann.

Der zylindrische Behälter ist im übrigen über einen Verbindungsstutzen, in den ein Isolationsventil eingeschaltet ist, mit einem zweiten Behälter verbunden, in dem das Granulat bevorratet ist, wobei ein von Hand bewegbarer Kolben dieses Granulat bei geöffnetem Ventil in den Verbindungsstutzen und damit in den Behälter mit Zumeßscheibe transportiert.

Schließlich ist eine Vorrichtung bekannt (US 3,998,686), die die kontinuierliche Zuführung von Schmelzgut zum Schmelztiegel beim Ziehen von Einkristallen im Vakuum ermöglicht und die aus zwei Behältern, einem Trennventil und einem mit dem einen Behälter verbundenen Auslaufrohr besteht, das durch die Wand des Vakuumkessels hindurchgeführt ist und oberhalb des Schmelztiegels einmündet.

Der vorliegenden Erfindung liegt die Aufgabe zugrunde, eine Vorrichtung des eingangs genannten Typs zu schaffen, die besonders zuverlässig und gleichmäßig arbeitet, deren Funktion gut überwachbar ist, die kontinuierlich und nicht portionsweise arbeitet und die einen praktisch ununterbrochenen Betrieb ermöglicht.

Erfindungsgemäß wird dies dadurch erreicht, daß der erste Behälter mit einer innenliegenden, der Behälterform angepaßten Auskleidung, mit einem trichterförmigen Abschnitt und einem sich an diesen anschließenden zylindrischen Auslauf versehen ist, wobei der Auslauf über das Schleusenventil bis in den Verbindungsstutzen des zweiten Behälters verschiebbar ist, der seinerseits über ein durch die Wand des Vakuumkessels hindurchgeführtes Auslaufrohr in den Bereich oberhalb des Schmelztiegels einmündet.

Vorzugsweise ist der die trichterförmige Partie der Auskleidung umschließende Abschnitt des ersten Behälters über einen Faltenbalg mit dem einlaßseitigen Teil des Schleusenventils druckdicht verbunden, wobei das auslaßseitige Teil des Schleusenventils über den Verbindungsstutzen mit der Oberseite des zweiten Gehäuses druckfest verbunden ist.

Damit wird eine möglichst lückenlose Auskleidung der einzelnen Teile der Vorrichtung mit einem nichtmetallischen Werkstoff, beispielsweise mit Quarzglas, ermöglicht, so daß ein Einschleusen von Metallabrieb in die Schmelze ausgeschlossen wird.

Um eine Zerstörung der Auskleidung durch das Schließen des Schleusenventils zu vermeiden, ist der obere Behälter über einen Haltearm mit dem Stellglied einer Vorrichtung gekoppelt, über die der Abstand zwischen den beiden Behältern veränderbar ist.

Mit Vorteil ist dabei der das Schleusenventil mit dem zweiten, unteren Behälter verbindende Stutzen mit einer innenliegenden, rohrförmigen Auskleidung versehen, deren unteres Ende bis in den zweiten Behälter hinein verlängert und als trichterförmige Partie ausgebildet ist.

Um eine gleichmäßige Bewegung des Granulats zu gewährleisten, ist im zweiten Behälter eine Rüttelvorrichtung mit einer von dieser bewegten Schale, in die die trichterförmige Partie der rohrförmigen Auskleidung oder der diese umschließende Verbindungsstutzen von oben her einmündet, wobei die Schale einen Auslauf oder eine Tülle aufweist, die mit dem Auslaufrohr korrespondiert.

Zweckmäßigerweise ist das Auslaufrohr von einem Schutzrohr zumindest teilweise umschlossen, dessen eines Ende fest mit dem zweiten Behälter und dessen anderes Ende fest mit dem Flansch eines Faltenbalgs verbunden ist.

Um den Transport des Granulats vom zweiten Behälter in das Auslaufrohr auch optisch überwachen zu können, ist das Schutzrohr mit Öffnungen oder Aussparungen versehen und das Auslaufrohr aus einem durchscheinenden Werkstoff, beispielsweise Quarz, gebildet.

Zweckmäßigerweise umschließt der Faltenbalg das freie Ende des Auslaufrohrs, wobei das tiegelseitige Ende des Faltenbalgs einen Flansch aufweist, der mit dem einen Ende eines sich bis in den Bereich des

EP 0 314 858 B1

Schmelztiegels erstreckenden Krümmers verbindbar ist.

Auf diese Weise ist es möglich, die Vorrichtung in unmittelbarer Nachbarschaft des Vakumkessels anzuordnen, da alle Vibrationen, die durch die Schüttelvorrichtung erzeugt werden könnten, vom die Wandung des Kessels durchgreifenden Auslaufkrümmer isoliert sind.

Um ein Öffnen des Deckels des die Vakuumkammer bildenden Kessels zu ermöglichen, ist zwischen dem Auslaufrohr und dem Krümmer ein bewegliches Glied angeordnet, wozu die beiden Flansche des Faltenbalgs über Zugfedern miteinander verbunden und an Bolzen gegeneinander geführt sind, wobei das tiegelseitige Ende des Auslaufrohrs druckdicht vom tiegelseitigen Flansch umschlossen ist. Der tiegelseitige Flansch ist weiterhin zweiteilig ausgebildet, wobei das zweite Teil fest an den Krümmer angeschlossen ist, so daß an dieser Stelle das Auslaufrohr vom Krümmer trennbar ist.

In einer bevorzugten Ausführungsform weist der Verbindungsstutzen zwischen dem Schleusenventil und dem zweiten Behälter einander diametral gegenüberliegende Bohrungen auf, wobei Sensoren einer Lichtschranke in der Fluchtlinie dieser Bohrungen angeordnet sind, die eine genaue Kontrolle der bevorrateten Menge an Schüttgut ermöglichen.

Um einen kontrollierten Auslauf des Granulats vom ersten Behälter in den Verbindungsstutzen zu ermöglichen, ist ein im ersten Behälter verschiebbar angeordneter Stopfen zu Verschließen der trichterförmigen Partie der Auskleidung vorgesehen, dessen deckelseitiges Ende mit einem Seilzug verbunden ist, der mit einer im oberen Teil der Wand des Behälters drehbar gelagerten Spindel zusammenwirkt, wobei ein Drehen der Spindel eine Verkürzung des freien Teils des Seilzugs, ein Anheben des Stopfens und damit den Auslauf des Schüttguts bewirkt.

Zweckmäßigerweise ist die Rüttelvorrichtung mit der an ihrer oberen Stirnseite angeordneten Schale auf der Innenseite des nach unten zu abnehmbaren Deckels befestigt, wobei der Deckel über einen Arm mit der vertikal bewegbaren Verriegelungsstange einer Stellvorrichtung in Wirkverbindung steht. Auf diese Weise ist sichergestellt, daß auch der untere Behälter geöffnet werden kann, ohne daß die Vorrichtung insgesamt demontiert oder bewegt werden muß.

Die Erfindung läßt die verschiedensten Ausführungsmöglichkeiten zu ; eine davon ist in den anhängenden Zeichnungen schematisch näher dargestellt, und zwar zeigen :

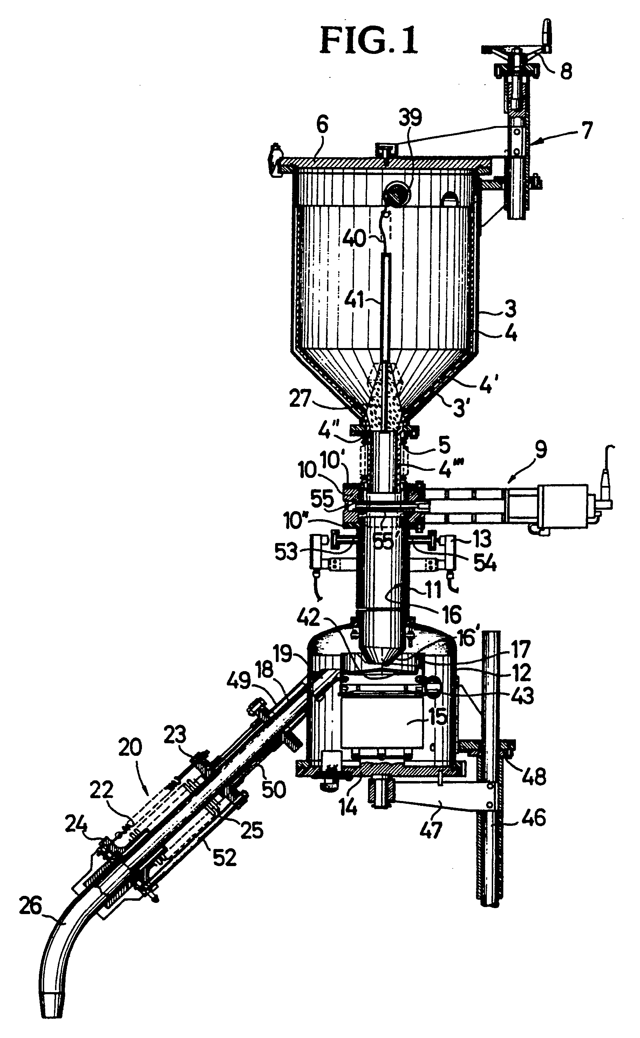

Figur 1    einen Längsschnitt durch die nachfüllbare, kontinuierlich arbeitende Chargiervorrichtung,

Figur 2    die Draufsicht auf die Vorrichtung nach Figur 1 mit einem Teilschnitt durch den unteren Behälter und

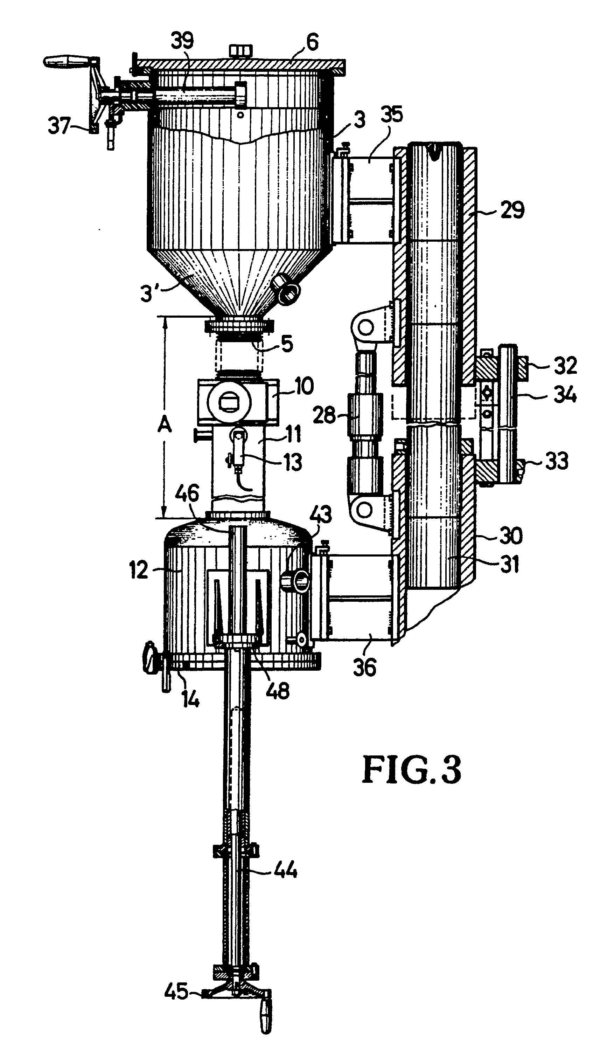

Figur 3    eine Seitenansicht der Vorrichtung

Die Vorrichtung besteht im wesentlichen aus dem oberen, mit einer Auskleidung 4 versehenen Behälter 3, einem mit dem konischen Abschnitt 3' des Behälters 3 verbundenen Faltenbalg 5, einem den Behälter 3 verschließenden Deckel 6, der über eine Schließeinrichtung 7 mit Handrad 8 betätigbar ist, einem über eine Betätigungseinrichtung 9 zu öffnendes Schleusenventil 10, einem Verbindungsstutzen 11 mit Lichtschranke 13, einem unteren Behälter 12 mit einer in diesem angeordneten und am Deckel 14 befestigten Rüttelvorrichtung 15, einer aus Spindel 44 mit Handrad 45, Verriegelungsstange 46 mit Haltearm 47 und Führungslager 48 gebildeten Vorrichtung zum Öffnen und Schließen des Deckels 14, einem am Verbindungsstutzen 11 vorgesehenen Auslauftrichter 16', der in eine Schale 17 aus Quarzglas einmündet, die wiederum mit dem Auslaufrohr 18 über eine Tülle 19 in Verbindung steht, und schließlich einem Federungskörper 20 mit Schraubenfedern 21, 22, die den Flanschen 23, 24 angreifen, einem Faltenbalg 25 und einem Krümmer 26.

Der Funktionsablauf der Chargiervorrichtung ist wie folgt :

Der kegelförmige Stopfen 27 wird in den trichterförmigen Auslauf 4″ der Auskleidung 4 gesetzt und das Schüttgut eingefüllt. Der obere Deckel 6 wird geschlossen und der obere Behälter 3 evakuiert.

Wenn der Druckausgleich zum oberen und unteren Behälter 12 gegeben ist, öffnet das Schleusenventil 10. In der geöffneten Stellung gibt das Schleusenventil 10 das Absinken des oberen Behälters 3 frei. Der obere Behälter 3 bewegt sich über den Faltenbalg 5 hydraulisch nach unten, wozu die aus Figur ersichtlichen, aus dem Hydrozylinder 28, den Führungsrohren 29, 30 mit Führungsrohren 32, 33, der Führungsstange 31, dem Bolzen 34 und den Haltearmen 35, 36 bestehende Stellvorrichtung vorgesehen ist.

Der zylindrische Ablauf 4‴ der Auskleidung 4 führt durch das Schleusenventil 10 in den zylindrischen Verbindungsstutzen 11. In dem Schleusenventil 10 ist eine Lippendichtung angebracht, die den Auslauf 4‴ der Auskleidung 4 abdichtet. Hierdurch kann kein Staub in das Schleusenventil 10 gelangen.

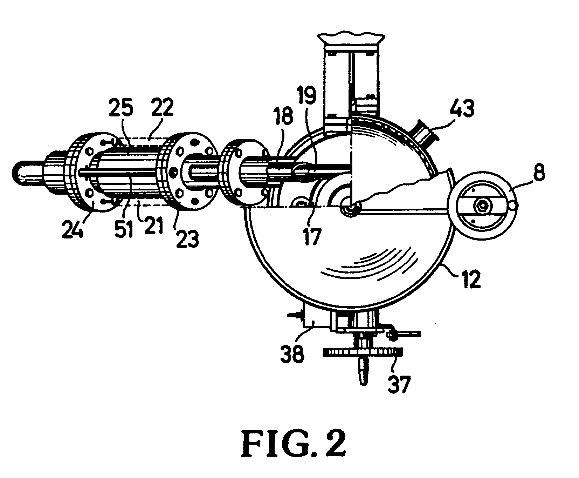

In der unteren Stellung des oberen Behälters 3 wird das Handrad 37 (Figur 2), das über einen Magneten 38 abgesichert ist, freigegeben, und der Stopfen 27 im trichterförmigen Auslauf 4″ kann durch Drehen des Handrads 37 über die Spindel 39, das Drahtseil 40 und die Stange 41 nach oben bewegt werden.

Das Schüttgut fällt durch den zylindrischen Auslauf 4‴, der oberhalb des Rüttlers 15 befestigt ist, auf den Behälterboden 42 des Rüttlers 15. Das Schüttgut staut sich in dem Behälter 17 über dem Rüttler. Durch die

3

variierende Bewegung des Rüttlers 15 wird das Schüttgut über eine Auslaufrinne oder Tülle 19 zum Auslaufrohr und von dort aus über den Krümmer 26 in den Schmelztiegel gebracht.

Durch das Schauglas 43 im Stutzen 44 des unteren Behälters 12 ist eine optische Kontrolle des Chargierguts, welches zum Schmelztiegel gebracht wird, möglich.

Die im wesentlichen zylindrische Auskleidung 4 ist an ihrem unteren Ende konisch ausgeführt. Der konische Abschnitt 4' ist je nach Schüttgut unterschiedlich. Der Abstand zwischen dem unteren Ende des konischen Abschnitts 4' und dem Boden 42 des Behälters 17 ist einstellbar und je nach Konusausführung auf ein bestimmtes Maß abstimmbar.

Die Lichtschranke 13 dient als Füllstandanzeige des oberen Behälters 3. Ist das Füllgut des oberen Behälters 3 bis auf die Ebene der Lichtschranke 13 abgesackt, wird der obere Behälter 3 hydraulisch über die Einrichtung 28 bis 36 nach oben geführt. Der Durchgang der Schleuse wird frei, und das Schleusenventil 10 schließt automatisch. Der obere Behälter 3 wird geflutet, der Deckel 6 über die Schließeinrichtung 7 geöffnet und der Stopfen 27 im trichterförmigen Auslauf 4" geschlossen.

Danach kann neues Schüttgut in den oberen Behälter 3 eingebracht werden. Der Vorgang des Chargierens wiederholt sich wie oben beschrieben. Dieser Nachfüllvorgang des oberen Behälters 3 kann beliebig fortgeführt werden. Während des Nachchargierens befindet sich soviel Schüttgut im Verbindungsstutzen 11 bzw. in der Schale 17, daß das kontinuierliche Nachfüllen des Schmelztiegels nicht unterbrochen wird.

Es sei noch erwähnt, daß der zylindrische Auslauf 4"' von den Dichtlippen zweier Dichtungen 55, 55' umschlossen ist, wenn sich der obere Behälter 3 in seiner abgesenkten Position befindet, so daß in der Auskleidung 16 aufsteigender Staub das Schleusenventil 10 vor einer Verschmutzung schützt. Die Dichtungen 55, 55' sind dazu so angeordnet, daß sich eine Dichtung 55' oberhalb und die andere Dichtung 55 unterhalb des Ventilschiebers befindet.

# Bezugszeichenliste

| | |
|---|---|
| 3 | oberer Behälter |
| 3' | konischer Abschnitt des Behälters |
| 4 | Auskleidung |
| 4' | konischer Abschnitt der Auskleidung |
| 4'' | trichterförmiger Auslauf |
| 4''' | zylindrischer Auslauf |
| 5 | Faltenbalg |
| 6 | Deckel |
| 7 | Schließeinrichtung |
| 8 | Handrad |
| 9 | Betätigungseinrichtung |
| 10 | Schleusenventil |
| 10' | einlaßseitiges Gehäuseteil |
| 10'' | auslaßseitiges Gehäuseteil |
| 11 | Verbindungsstutzen |
| 12 | unterer Behälter |
| 13 | Lichtschranke |
| 14 | Deckel |
| 15 | Rüttelvorrichtung |
| 16 | rohrförmige Auskleidung |
| 16' | Auslauftrichter, trichterförmige Partie |
| 17 | Schale |
| 18 | Auslaufrohr |
| 19 | Tülle |
| 20 | Federungskörper |
| 21 | Schraubenfeder |
| 22 | Schraubenfeder |

| | |
|---|---|
| 23 | Flansch |
| 24 | Flansch |
| 25 | Faltenbalg |
| 26 | Krümmer |
| 27 | Stopfen |
| 28 | Hydrozylinder |
| 29 | Führungsrohr |
| 30 | Führungsrohr |
| 31 | Führungsstange |
| 32 | Führungsrohr |
| 33 | Haltearm |
| 34 | Bolzen, Führungsbolzen |
| 35 | Haltearm |
| 36 | Haltearm |
| 37 | Handrad |
| 38 | Magnet |
| 39 | Spindel, Welle |
| 40 | Drahtseil |
| 41 | Stange |
| 42 | Behälterboden |
| 43 | Schauglas |
| 44 | Spindel |
| 45 | Handrad |
| 46 | Verriegelungsstange |
| 47 | Haltearm |
| 48 | Führungslager |
| 49 | Schutzrohr |
| 50 | Aussparung |
| 51 | Bolzen, Führungsbolzen |
| 52 | Bolzen, Führungsbolzen |
| 53 | Bohrung, Schauglas |
| 54 | Bohrung, Schauglas |
| 55, 55' | Lippendichtung |

## Patentansprüche

1. Vorrichtung für die kontinuierliche Zuführung von Schmelzgut für den Schmelztiegel beim Ziehen von Einkristallen in einem Vakuumkessel mit verschließbaren Behältern (3, 12), einem Trenn- oder Schleusenventil (10) und einem in den Bereich oberhalb des Schmelztiegels einmündenden, mit dem einen Behälter (12) verbundenen und durch die Wand des Vakuumkessels hindurchgeführten Auslaufrohr (18) bzw. Krümmer (26),

6

*dadurch gekennzeichnet*, daß der erste Behälter (3) mit einer innenliegenden, der Behälterform entsprechenden Auskleidung (4), mit einem trichterförmigen Abschnitt (4′) und einem sich an diesen anschließenden zylindrischen Auslauf (4″) versehen ist, wobei der Auslauf (4″) über das Schleusenventil (10) bis in den Verbindungsstutzen (11) des zweiten Behälters (12) verschiebbar ist.

2. Vorrichtung nach Anspruch 1, *dadurch gekennzeichnet*, daß der die trichterförmige Partie (4′) der Auskleidung (4) umschließende Abschnitt (3′) des ersten Behälters (3) über einen Faltenbalg (5) mit dem einlaßseitigen Teil (10′) des Schleusenventils (10) druckdicht verbunden ist, wobei das das auslaßseitige Teil (10″) des Schleusenventils (10) über Verbindungsstutzen (11) mit der Oberseite der Partie des zweiten Gehäuses (12) druckfest verbunden ist.

3. Vorrichtung nach den Ansprüchen 1 und 2, *dadurch gekennzeichnet*, daß der obere Behälter (3) über einen Haltearm (35) mit dem Stellglied einer Vorrichtung (28 bis 36) gekoppelt ist, über das der Abstand (A) zwischen den beiden Behältern (3 und 12) veränderbar ist.

4. Vorrichtung nach den Ansprüchen 1 bis 3, *dadurch gekennzeichnet*, daß der das Schleusenventil (10) mit dem zweiten, unteren Behälter (12) verbindende Stutzen (11) mit einer innenliegenden, rohrförmigen Auskleidung (16) versehen ist, deren unteres Ende bis in den zweiten Behälter (12) hinein verlängert und als trichterförmige Partie (16′) ausgebildet ist.

5. Vorrichtung nach den Ansprüchen 1 bis 4, *gekennzeichnet durch* eine im zweiten Behälter (12) angeordnete Rüttelvorrichtung (15) mit einer von dieser bewegten Schale (17), in die die trichterförmige Partie (16′) der rohrförmigen Auskleidung oder der diese umschließende Verbindungsstutzen (11) von oben her einmündet, wobei die Schale (17) einen Auslauf oder eine Tülle (19) aufweist, die mit dem Auslaufrohr (18) korrespondiert.

6. Vorrichtung nach einem oder mehreren der vorhergehenden Ansprüche, *dadurch gekennzeichnet*, daß das Auslaufrohr (18) von einem Schutzrohr (49) zumindest teilweise umschlossen ist, dessen eines Ende fest mit dem zweiten Behälter (12) und dessen anderes Ende fest mit dem Flansch (23) eines Faltenbalgs (25) verbunden ist.

7. Vorrichtung nach Anspruch 6, *dadurch gekennzeichnet*, daß das Schutzrohr (49) mit Öffnungen oder Aussparungen (50) versehen ist und das Auslaufrohr (18) aus einem durchscheinenden Werkstoff, beispielsweise Quarz, gebildet ist.

8. Vorrichtung nach den Ansprüchen 6 und 7, *dadurch gekennzeichnet*, daß der Faltenbalg (25) das freie Ende des Auslaufrohrs (18) umschließt, wobei das tiegelseitige Ende des Faltenbalgs (25) einen Flansch (24) aufweist, der mit dem einen Ende eines sich bis in den Bereich des Schmelztiegels erstrekkenden Krümmer (26) verbindbar ist.

9. Vorrichtung nach den Ansprüchen 6 bis 8, *dadurch gekennzeichnet*, daß die beiden Flansche (23, 24) des Faltenbalgs (25) über Zugfedern (21, 22) miteinander verbunden und auf Bolzen (51, 52) zueinander geführt sind, wobei das tiegelseitige Ende des Auslaufrohrs (18) druckdicht vom tiegelseitigen Flansch (24) umschlossen ist.

10. Vorrichtung nach einem oder mehreren der vorhergehenden Ansprüche, *dadurch gekennzeichnet*, daß der Verbindungsstutzen zwischen dem Schleusenventil (10) und dem zweiten Behälter (12) einander diametral gegenüberliegende Bohrungen (53, 54) aufweist, wobei Sensoren einer Lichtschranke (13) in der Fluchtlinie dieser Bohrungen (53, 54) angeordnet sind.

11. Vorrichtung nach einem oder mehreren der vorhergehenden Ansprüche, *gekennzeichnet durch* einen im ersten Behälter (3) verschieblich angeordneten Stopfen (27) zum Verschließen der trichterförmigen Partie (4″) der Auskleidung (4), dessen deckelseitiges Ende mit einem Seilzug (40) verbunden ist, der mit einer im oberen Teil der Wand des Behälters drehbar gelagerten Spindel (39) zusammenwirkt, wobei ein Drehen der Spindel eine Verkürzung des freien Teils des Seilzugs (40) und damit ein Anheben des Stopfens (27) bewirkt.

12. Vorrichtung nach einem oder mehreren der vorhergehenden Ansprüche, *dadurch gekennzeichnet*, daß die Rüttelvorrichtung (15) mit dem an ihrer oberen Stirnseite angeordneten Schale (17) auf der Innenseite des nach unten zu abnehmbaren Deckels (14) befestigt ist, wobei der Deckel (14) über einen Arm (47) mit der vertikal bewegbaren Verriegelungsstange (46) einer Stellvorrichtung (44 bis 48) in Wirkverbindung steht.

13. Vorrichtung nach einem oder mehreren der vorhergehenden Ansprüche, *dadurch gekennzeichnet*, daß das Schleusenventil (10) eine mit dem zylindrischen Auslauf (4″) zusammenwirkende Lippendichtung (55, 55′) aufweist, die bei geöffnetem Auslauf (4″, 27) das Schleusenventil (10) vor Verschmutzung durch in der Auskleidung (16) aufsteigenden Staub schützt.

## Claims

1. Apparatus for the continuous supply of material to be melted for the melting pot in the pulling of monocrystals in a vacuum tank with sealable tanks (3, 12), with a separating or sluice valve (10), and with an outlet pipe (18) or elbow (26), which opens into the region above the melting pot, is connected to one of the tanks (12), and is passed through the wall of the vacuum tank, characterised in that the first tank (3) is provided with an internal lining (4), conforming to the tank shape and having a funnel-shaped section (4'), and with a cylindrical outlet (4") adjoining the latter, the outlet (4") being slidable via the sluice valve (10) into the joining nozzle (11) of the second tank (12).

2. Apparatus according to claim 1, characterised in that the section (3') of the first tank (3) enclosing the funnel-shaped part (4') of the lining (4) is connected to the inlet-side part (10') of the sluice valve (10) in a pressure-tight manner via a concertina-type member (5), the outlet-side part (10") of the sluice valve (10) being connected in a pressure-tight manner via a joining nozzle (11) to the upper side of the part of the second housing (12).

3. Apparatus according to claims 1 and 2, characterised in that the upper tank (3) is coupled via a holding arm (35) to the control member of a device (28 to 36) for varying the distance (A) between the two tanks (3 and 12).

4. Apparatus according to claims 1 to 3, characterised in that the nozzle (11) joining the sluice valve (10) to the second, lower tank (12) is provided with an internal, tubular lining (16), whose lower end is extended into the second tank (12) and is formed as a funnel-shaped part (16').

5. Apparatus according to claims 1 to 4, characterised by a shaker device (15) with a dish (17) moved thereby, into which the funnel-shaped part (16') of the tubular lining or the joining nozzle (11) enclosing same opens from above, the dish (17) having an outlet or spout (19), which corresponds to the outlet pipe (18).

6. Apparatus according to one or more of the preceding claims, characterised in that the outlet pipe (18) is at least partly enclosed by a protective tube (49), which is permanently connected by one end to the second tank (12), and by the other end permanently to the flange (23) of a concertina-type member (25).

7. Apparatus according to claim 6, characterised in that the protective tube (49) is provided with apertures or recesses (50) and the outlet pipe (18) is formed of a transparent material, e.g. quartz.

8. Apparatus according to claims 6 and 7, characterised in that the concertina-type member (25) encloses the free end of the outlet pipe (18), the end of the concertina-type member (25) on the melting pot side having a flange (24), which is connectable to one end of an elbow (26) extending as far as the melting pot.

9. Apparatus according to claims 6 to 8, characterised in that the two flanges (23, 24) of the concertina-type member (25) are connected together via tension springs (21, 22) and are guided to one another on bolts (51, 52), the end of the outlet pipe (18) on the melting pot side being enclosed in a pressure-tight manner by the flange (24) on the melting pot side.

10. Apparatus according to one or more of the preceding claims, characterised in that the joining nozzle between the sluice valve (10) and the second tank (12) has diametrically opposite bores (53, 54), and sensors of a light barrier (13) are mounted in the vanishing line of these bores (53, 54).

11. Apparatus according to one or more of the preceding claims, characterised by a bung (27) mounted slidably in the first tank (3) for sealing the funnel-shaped part (4") of the lining (4), whose end on the lid side is connected to a cable pull (40), which cooperates with a spindle (39) rotatably mounted in the upper part of the wall of the tank, rotation of the spindle effecting shortening of the free part of the cable pull (40) and thereby lifting of the bung (27).

12. Apparatus according to one or more of the preceding claims, characterised in that the shaker device (15) is fixed to the dish (17) mounted on its upper end face on the inside of the lid (14), which is to be removed from below, the lid (14) being actively connected via an arm (47) to the vertically movable stay bar (46) of a control device (44 to 48).

13. Apparatus according to one or more of the preceding claims, characterised in that the sluice valve (10) has a lip seal (55, 55'), which cooperates with the cylindrical outlet (4") and which, when the outlet (4", 27) is open, protects the sluice valve (10) from contamination by dust rising in the lining (16).

## Revendications

1. Dispositif pour l'amenée continue de matière à fondre, destinée au creuset de fusion, lors du tirage de monocristaux dans une enceinte sous vide, comportant des récipients obturables (3, 12), une vanne de séparation ou vanne de sassage (10) et un tuyau de sortie (18) et/ou un tuyau courbé (26) qui a son embouchure dans la région au-dessus du creuset de fusion, est relié au premier récipient (12) et traverse la paroi de l'enceinte sous vide, caractérisé par le fait que le premier récipient (3) est muni d'un habillage (4) situé intérieurement, correspondant à la forme du récipient, avec une partie en forme d'entonnoir (4') et, succédant à celle-ci, une sortie cylindrique (4"), la sortie (4") pouvant être déplacée, via la vanne de sassage (10), jusque dans la tubulure de liaison (11) du deuxième récipient (12).

2. Dispositif selon revendication 1, caractérisé par le fait que la partie (3') du premier récipient (3) entourant la partie en forme d'entonnoir (4') de l'habillage (4) est reliée avec étanchéité à la pression, par l'intermédiaire d'un soufflet (5), à la partie côté entrée (10') de la vanne de sassage (10), la partie côté sortie (10") de la vanne de sassage (10) étant reliée, par tubulure de liaison (11), de manière à résister à la pression, au côté supérieur de la partie du deuxième récipient (12).

3. Dispositif selon les revendications 1 et 2, caractérisé par le fait que le récipient supérieur (3) est couplé, par l'intermédiaire d'un bras-support (35), à l'organe positionneur d'un dispositif (28 à 36) par lequel la distance (A) entre les deux récipients (3 et 12) peut être modifiée.

4. Dispositif selon les revendications 1 à 3, caractérisé par le fait que la tubulure (11) reliant la vanne de sassage (10) au deuxième récipient (12), lequel est le récipient inférieur, est munie d'un habillage intérieur tubulaire (16) dont l'extrémité inférieure est prolongée jusque dans le deuxième récipient (12) et est réalisée en tant que partie en forme d'entonnoir (16').

5. Dispositif selon les revendications 1 à 4, caractérisé par un dispositif secoueur (15) agencé dans le deuxième récipient (12) et déplaçant une coupelle (17) dans laquelle la partie en forme d'entonnoir (16') de l'habillage tubulaire, ou la tubulure de liaison (11) entourant cet habillage, débouche par le haut, la coupelle (17) présentant une sortie ou un organe de traversée (19) qui correspond avec le tuyau de sortie (18).

6. Dispositif selon une ou plusieurs des revendications précédentes, caractérisé par le fait que le tuyau de sortie (18) est au moins partiellement entouré par un tube protecteur (49) dont une extrémité est solidarisée au deuxième récipient (12) et dont l'autre extrémité est solidarisée à la bride (23) d'un soufflet (25).

7. Dispositif selon revendication 6, caractérisé par le fait que le tube protecteur (49) est muni d'ouvertures ou évidements (50) et par le fait que le tuyau de sortie (18) est en une matière transparente, par exemple quartz.

8. Dispositif selon les revendications 6 et 7, caractérisé par le fait que le soufflet (25) entoure l'extrémité libre du tuyau de sortie (18), l'extrémité du soufflet (25) située côté creuset présentant une bride (24) qui peut être liée à la première extrémité d'un tuyau courbé (26) s'étendant dans la région du creuset de fusion.

9. Dispositif selon les revendications 6 à 8, caractérisé par le fait que les deux brides (23, 24) du soufflet (25) sont mutuellement liées par l'intermédiaire de ressorts (21, 22) et sont guidées l'une par rapport à l'autre sur des axes (51, 52), l'extrémité du tuyau de sortie (18) située côté creuset étant entourée, avec étanchéité à la pression, par la bride (24) située côté creuset.

10. Dispositif selon une ou plusieurs des revendications précédentes, caractérisé par le fait que la tubulure de liaison entre la vanne de sassage (10) et le deuxième récipient (12) présente des trous diamétralement opposés (53, 54), des capteurs d'une barrière photoélectrique (13) étant agencés dans la ligne d'alignement de ces trous (53, 54).

11. Dispositif selon une ou plusieurs des revendications précédentes, caractérisé par le fait qu'un bouchon (27) pour fermer la partie en forme d'entonnoir (4") de l'habillage (4) est agencé avec possibilité de déplacement dans le premier récipient (3), l'extrémité de ce bouchon située côté couvercle étant reliée à un câble (40) qui coopère avec une broche (39) montée à rotation dans la partie supérieure de la paroi du récipient, une rotation de la broche provoquant un raccourcissement de la partie libre du câble (40) et par conséquent un soulèvement du bouchon (27).

12. Dispositif selon une ou plusieurs des revendications précédentes, caractérisé par le fait que le dispositif secoueur (15) avec la coupelle (17) agencée sur son côté extrême supérieur est fixé sur le côté intérieur du couvercle (14) pouvant être enlevé vers le bas, le couvercle (14) étant, par l'intermédiaire d'un bras (47), en liaison fonctionnelle avec la tige de verrouillage (46), mobile verticalement, d'un dispositif positionneur (44 à 48).

13. Dispositif selon une ou plusieurs des revendications précédentes, caractérisé par le fait que la vanne de sassage (10) présente un organe d'étanchéité à lèvres (55, 55') qui coopère avec la sortie cylindrique (4"') et qui, lorsque la sortie (4", 27) est ouverte, protège la vanne de sassage (10) contre l'encrassement par la poussière montant dans l'habillage (16).

# FIG.1

# FIG. 2

FIG.3